# EUROPÄISCHE PATENTANMELDUNG

(11) **EP 4 276 916 A1**
(43) Veröffentlichungstag der Anmeldung: **15.11.2023**
(21) Anmeldenummer: 23172427.9
(22) Anmeldetag: 09.05.2023
(51) Int. Cl.: H01L 31/048, B32B 17/04

(54) **PHOTOVOLTAIK-PANEEL UND VERFAHREN ZUM HERSTELLEN EINES PHOTOVOLTAIK-PANEELS**

(30) Priorität: 09.05.2022 AT 503262022
(71) Anmelder: DAS ENERGY LIMITED, 3026 Limassol (CY)
(72) Erfinder: Dries, Christian, 2522 Oberwaltersdorf (AT)
(74) Vertreter: Beer & Partner Patentanwälte KG

(57) **Zusammenfassung**

Ein Photovoltaik-Paneel umfasst eine an der dem Licht zugewandten Seite vorgesehene, flächige und transparente Frontabdeckung (4), eine an der dem Licht abgewandten Seite vorgesehene, flächige Rückseitenabdeckung (5), wobei die Front- und Rückseitenabdeckung (4, 5) jeweils einen umlaufenden Rand haben, und wenigstens eine Solarzelle (1) zwischen der Front- und Rückseitenabdeckung (4, 5). Zwischen der wenigstens einen Solarzelle (1) und der Frontabdeckung (4) und/oder zwischen der wenigstens einen Solarzelle (1) und der Rückseitenabdeckung (5) ist wenigstens ein Fasermaterial (3), das die wenigstens eine Solarzelle (1) bedeckt, vorgesehen, wobei das Fasermaterial (3) vorzugsweise ein Verbundmaterial, insbesondere ein mit Fasern verstärkter Kunststoff, ist. Die Front- und Rückseitenabdeckung (4, 5) ragen jeweils in Richtung ihres Randes über das Fasermaterial (3) hinaus, so dass das Fasermaterial (3) derart von den Rändern der Front- und Rückseitenabdeckung (4, 5) beabstandet ist, dass ein Randbereich (6) frei von Fasermaterial (3) ist. Die Front- und Rückseitenabdeckung (4, 5) sind in dem Randbereich (6), der frei von Fasermaterial (3) ist, miteinander verbunden.

## Beschreibung

Die Erfindung betrifft ein Photovoltaik-Paneel, umfassend eine an der dem Licht zugewandten Seite vorgesehene, flächige und transparente Frontabdeckung, eine an der dem Licht abgewandten Seite vorgesehene, flächige Rückseitenabdeckung, wobei die Front- und Rückseitenabdeckung jeweils einen umlaufenden Rand hat, und wenigstens eine Solarzelle zwischen Front- und Rückseitenabdeckung, wobei zwischen der wenigstens einen Solarzelle und der Frontabdeckung und/oder zwischen der wenigstens einen Solarzelle und der Rückseitenabdeckung wenigstens ein Fasermaterial, das die wenigstens eine Solarzelle bedeckt, vorgesehen ist und wobei das Fasermaterial vorzugsweise ein Verbundmaterial, insbesondere ein mit Fasern verstärkter Kunststoff, ist.

Die Erfindung betrifft zudem ein Verfahren zum Herstellen eines solchen Photovoltaik-Paneels.

Es ist bekannt, leichtgewichtige Photovoltaik-Paneele herzustellen, deren mechanische Festigkeit durch Faserverbundwerkstoffe, die über die gesamte Paneelfläche vor und hinter den elektrisch leitenden Bauteilen vorgesehen sind, erreicht wird. Solche Paneele haben den Vorteil, dass diese nicht nur leicht, sondern auch flexibel sind, da auf Glasplatten im Schichtaufbau des Paneels verzichtet werden kann.

Es ist weiterhin bekannt, dass die Faserverbundwerkstoffe bis zum Rand dieser Paneele eingebaut werden. Nachteilig dabei ist, dass auf Grund der Kapillarwirkung der Fasern die Möglichkeit eines erhöhten Feuchtigkeitseintrittes besteht, wodurch das Risiko eines Defektes auf Grund von Korrosion der elektrisch leitenden Bauteile oder Delamination der einzelnen Schichten des Paneels entsteht.

Der Erfindung liegt die Aufgabe zu Grunde, derartige Defektrisiken zu vermeiden.

Gelöst wird diese Aufgabe erfindungsgemäß durch ein Photovoltaik-Paneel mit den Merkmalen des Anspruchs 1 und ein Verfahren mit den Merkmalen des Anspruches 11.

Bevorzugte Ausführungsformen der Erfindung sind Gegenstand der Unteransprüche.

Erfindungsgemäß ist vorgesehen, dass die Front- und Rückseitenabdeckung jeweils in Richtung ihres Randes über das Fasermaterial hinausragt, so dass das Fasermaterial derart von den Rändern der Front- und Rückseitenabdeckung beabstandet ist, dass ein Randbereich frei von Fasermaterial ist, und dass die Front- und Rückseitenabdeckung in den Randbereichen, die frei von Fasermaterial sind, miteinander verbunden sind. Durch diese Kombination kann zuverlässig vermieden werden, dass Feuchtigkeit auf Grund der Kapillarwirkung der Fasern in den Schichtaufbau des Paneels eintritt.

In einer bevorzugten Ausführungsform der Erfindung ist vorgesehen, dass der Randbereich, der frei von Fasermaterial ist, zumindest entlang eines Teils der Ränder verläuft, vorzugsweise entlang eines überwiegenden Teils, insbesondere entlang der gesamten Ränder. Somit wird gewährleistet, dass an keiner Stelle des Randes Feuchtigkeit auf Grund der Kapillarwirkung in den Schichtaufbau des Paneels eintritt.

Besonders bevorzugt ist es, wenn die Front- und Rückseitenabdeckung in dem Randbereich, der frei von Fasermaterial ist, mittels eines Abdichtungsmaterials miteinander verbunden sind. Das Abdichtungsmaterial ist vorzugsweise wasser- und gasundurchlässig und die Randbereiche sind flüssigkeits- und gasdicht miteinander verbunden. Somit wird besonders zuverlässig vermieden, dass Feuchtigkeit überhaupt in den Schichtaufbau des Paneels eintreten kann.

In einer vorteilhaften Weiterbildung kann vorgesehen sein, dass das Abdichtungsmaterial eine thermoplastische oder duroplastische Folie und/oder ein Klebstoff, insbesondere ein pastöser und/oder flüssiger Kunststoff ist, mittels dem die Front- und Rückseitenfolien im Randbereich vorzugsweise vollflächig miteinander verklebt sind.

Eine thermoplastische oder duroplastische Folie, insbesondere eine beim Herstellen von Photovoltaik-Paneelen verwendete Einkapselungsfolie, hat grundsätzlich die Funktion, ein faserverstärktes Verbundmaterial mit der wenigstens einen Solarzelle zu verkleben, wodurch positive mechanische Eigenschaften des Paneels hervorgerufen werden. Die Verwendung einer Einkapselungsfolie kann von der Oberflächenbeschaffenheit der Solarzelle abhängen, wobei die Oberflächenbeschaffenheit auf der Vorder- und Rückseite der Solarzelle unterschiedlich sein kann. Die Rückseite der Solarzelle kann derart z.B. mit einer Aluminiumbeschichtung beschichtet sein, dass das Faser- bzw. Verbundmaterial ausreichend gut an der Solarzelle haftet. An der Vorderseite der Solarzelle ist dies im Hinblick auf Transparenz nicht ohne Weiteres möglich, weshalb eine Einkapselungsfolie zwischen der Vorderseite der Solarzelle und dem Faser- bzw. Verbundmaterial vorteilhaft ist. In diesem Fall wird ohnehin eine solche Folie im Schichtaufbau des herzustellenden Paneels angeordnet, so dass kein zusätzlicher Schritt zum Aufbringen eines zusätzlichen Abdichtungsmittels anfallen muss. Die Einkapselungsfolie kann sich über die gesamte Fläche der Solarzelle(n) sowie über die Fläche des erfindungsgemäß vorgesehenen Randbereiches erstrecken.

Wenn die Haftung des Faser- bzw. Verbundmaterials auf der Solarzelle ausreichend gegeben ist, reicht es aus, einen entsprechenden Klebstoff nur auf die Randbereiche, die fei von Fasern sind, aufzutragen. In diesem Fall kann auf das Anordnen einer Einkapselungsfolie verzichtet werden, was den Herstellungsprozess vereinfachen kann.

Im Rahmen der Erfindung ist der Randbereich, der frei von Fasermaterial ist, vorzugsweise flächig und verläuft im Wesentlichen parallel zu den Flächen der Front- und Rückseitenabdeckung. Der faserfreie Rand erstreckt sich somit im Wesentlichen in der Ebene des flächigen Paneels, so dass der Rand während des Laminierens des Schichtaufbaus ausgebildet wird.

Im Rahmen der Erfindung ist eine Ausführungsform bevorzugt, bei der die Front- und Rückseitenabdeckung in dem Randbereich, der frei von Fasermaterial ist, mittels einer zwischen der Solarzelle und dem an der dem Licht zugewandten Seite und/oder an der dem Licht abgewandten Seite vorgesehenen Fasermaterial vorgesehenen thermoplastischen oder duroplastischen Folie als Abdichtungsmaterial, deren Fläche sich über die gesamte Fläche der Front- und Rückseitenabdeckung erstreckt, miteinander verklebt sind. Somit wird die Aufgabe gelöst, die dauerhafte Funktionsfähigkeit des Paneels zu verbessern, da durch die konkrete Anordnung des Abdichtungsmaterials die Haftung innerhalb des Schichtaufbaus erhöht wird, indem gleichzeitig die mechanischen Verbundeigenschaften verbessert werden und ein Eindringen von Feuchtigkeit in den Schichtaufbau verhindert wird.

Im Rahmen der Erfindung kann die Frontabdeckung eine transparente Platte, insbesondere eine Glasplatte, oder eine transparente Folie (Frontfolie), insbesondere eine ETFE-Folie, sein. Die Frontabdeckung kann auch durch ein anderes, lichtdurchlässiges Material gebildet sein.

Ebenso kann die Rückseitenbedeckung eine stabile Platte oder eine Folie (Rückseitenfolie) sein, wobei auf der Rückseite jegliches, geeignetes Trägermaterial vorgesehen sein kann. Die Rückseitenabdeckung kann auch lichtundurchlässig sein.

In einer praktisch besonders bevorzugten Ausführungsform ist das Verbundmaterial ein mit Fasern verstärkter Kunststoff auf Harzbasis, insbesondere auf Basis eines Acrylats enthaltend Epoxidgruppen, wobei das Acrylat enthaltend Epoxidgruppen vorzugsweise Glycidylmethacrylat ist. Insbesondere kann ein in EP 2 863 443 A1 offenbartes Verbundmaterial verwendet werden.

Im Rahmen der Erfindung ist es bevorzugt, wenn das Verbundmaterial vor und hinter der Solarzelle vorgesehen ist und die Solarzelle beidseitig einkapselt. Das Verbundmaterial vorne muss transparent sein. Das Verbundmaterial hinten hat nicht die Anforderungen an Transparenz wie vorne, sondern es kann auf mechanische Eigenschaften des Paneels ausgelegt sein, z.B. durch einen höheren Anteil an Fasern oder durch unterschiedliche Flächengewichte der Fasern. Flächengewichte der Fasern können wie in EP 2 863 443 A1 offenbart gewählt werden.

Im Rahmen der Erfindung können die Fasern Glasfasern, Kunststofffasern, Carbonfasern, Natur- und/oder Steinfasern, beispielsweise Basaltfasern sein, die je nach ihren Eigenschaften und nach ihrer Anordnung im Paneel gewählt werden können.

Wenn das Fasermaterial vor der wenigstens einen Solarzelle, d.h. an der dem Licht zugewandten Seite, vorgesehen ist, werden als Fasern Glasfasern bevorzugt, da diese nicht nur geeignete mechanische Eigenschaften haben, sondern auch die Transparenz eines herzustellenden Verbundmaterials nicht beeinträchtigen. Wenn das Fasermaterial hinter der wenigstens einen Solarzelle, d.h. an der dem Licht abgewandten Seite, vorgesehen ist, dann muss nicht auf Transparenz geachtet werden, sondern die Fasern können je nach den gewünschten sonstigen Eigenschaften gewählt werden, z.B. Basalt- und/oder Carbonfasern.

Im Rahmen der Erfindung können weitere Schichten/Lagen, insbesondere Folien oder weitere Lagen an Fasermaterial, vorgesehen sein.

Um einen Feuchtigkeitseintritt in den Schichtaufbau des Paneels besonders zuverlässig zu verhindern, ist in einer Ausführungsform der Erfindung vorgesehen, dass das Fasermaterial mindestens 0,1 cm, vorzugsweise mindestens 0,5 cm, insbesondere 1cm, von den Rändern der Front- und/oder Rückseitenabdeckung beabstandet ist.

Zum Herstellen eines Photovoltaik-Paneels und zum Vermeiden von durch Kapillarwirkung der Fasern hervorgerufenen Defektrisiken sind erfindungsgemäß folgende Schritte vorgesehen:
- Bereitstellen und gegebenenfalls Zuschneiden eines Fasermaterials mit einer Fläche, die abhängig von der Fläche der wenigstens einen zu bedeckenden Solarzelle gewählt wird,
- Bereitstellen und gegebenenfalls Zuschneiden einer Front- und einer Rückseitenabdeckung mit einer Fläche, die größer ist als die Fläche des Fasermaterials,
- Anordnen der wenigstens einen Solarzelle und des Fasermaterials zwischen der Front- und Rückseitenabdeckung, wobei das Fasermaterial gegebenenfalls mit wenigstens einer weiteren Komponente zum Ausbilden des Verbundmaterials in Verbindung gebracht wird, wobei die Front- und Rückseitenabdeckung jeweils in Richtung ihres Randes über das Fasermaterial hinausragend angeordnet wird, so dass das Fasermaterial derart von den Rändern der Front- und Rückseitenabdeckung beabstandet ist, dass ein Randbereich frei von Fasermaterial gelassen wird,
- Laminieren des gesamten Aufbaus und Verbinden der Front- und Rückseitenabdeckung in den Randbereichen, die fei von Fasermaterial sind.

Die Fläche des Fasermaterials kann größer sein als die Fläche der wenigstens einen Solarzelle, so dass das Fasermaterial über die wenigstens eine Solarzelle hinausragt.

Obwohl für das Verständnis der Erfindung nicht notwendig, versteht es sich, dass vor dem Laminieren des Aufbaus elektrisch leitende Elemente und elektrische Anschlüsse angeordnet werden können.

In einer bevorzugten Weiterbildung des Herstellungsverfahrens ist vorgesehen, dass wenigstens ein Abdichtungsmaterial vorzugsweise vor dem Laminieren zwischen der Front- und Rückseitenabdeckung angeordnet wird. Insbesondere ist vorgesehen, dass wenigstens ein Abdichtungsmaterial auf die Fläche der Randbereiche der Front- und/oder Rückseitenabdeckung, die frei von Fasermaterial sind, aufgetragen wird, wobei das Abdichtungsmaterial diese Randbereiche miteinander verklebt. Ein Abdichtungsmaterial kann auch teilweise oder vollständig auf Bereiche, in denen Fasermaterial vorliegt, aufgetragen werden. Das Abdichtungsmaterial kann fest, pastös oder flüssig sein. Im Rahmen der Erfindung kann als Abdichtungsmaterial eine thermoplastische und/oder duroplastische Folie und/oder ein Klebstoff, insbesondere ein pastöser und/oder flüssiger Kunststoff, auf die Randbereiche, die frei von Fasermaterial sind, aufgetragen werden, wobei das Abdichtungsmaterial diese Randbereiche miteinander verklebt.

Beispielsweise kann als Abdichtungsmaterial eine Einkapselungsfolie verwendet werden, deren Fläche sich über die gesamte Fläche der Front- und/oder Rückseitenabdeckung erstreckt, wobei die Einkapselungsfolie das Fasermaterial durch das Laminieren an der Oberfläche der Solarzelle(n) anhaftet und die Randbereiche, die fei von Fasermaterial sind, miteinander verklebt.

Alternativ oder zusätzlich dazu kann ein Klebstoff, insbesondere ein pastöser und/oder flüssiger Klebstoff, nur auf die Randbereiche, die frei von Fasermaterial sind, aufgetragen werden, wobei der Klebstoff diese Randbereiche miteinander verklebt.

Als Fasermaterial kann ein Fasergewebe verwendet werden und als weitere Komponente kann ein Harz, vorzugsweise ein pulverförmiges Harz, insbesondere ein Acrylat enthaltend Epoxidgruppen, vorzugsweise Glycidylmethacrylat, auf das Fasergewebe aufgetragen werden. Es können auch andere Harzsysteme, beispielsweise basierend auf Polyester oder Epoxid, verwendet werden.

Im Rahmen der Erfindung ist es bevorzugt, wenn die Fläche des Fasermaterials und die Flächen der Front- und Rückseitenabdeckung derart bemessen werden, dass das Fasermaterial im Photovoltaik-Paneel mindestens 0,1 cm, vorzugsweise 0,5 cm, insbesondere 1 cm, von den Rändern der Front- und Rückseitenabdeckung beabstandet ist.

Weitere Merkmale und Vorteile ergeben sich aus der nachfolgenden Beschreibung der Zeichnungen. Es zeigt:
- Fig. 1: eine Draufsicht auf einen Ausschnitt eines bekannten Photovoltaik-Paneels, bei dem ein Fasermaterial bis zu den Rändern der Front- und Rückseitenfolie verläuft,
- Fig. 2: eine Draufsicht auf einen Ausschnitt eines erfindungsgemäßen Photovoltaik-Paneels, bei dem die Randbereiche der Front- und Rückseitenfolie frei von Fasermaterial sind, und
- Fig. 4 und 5: Schnittansichten von beispielhaften Schichtaufbauten vor dem Laminieren.

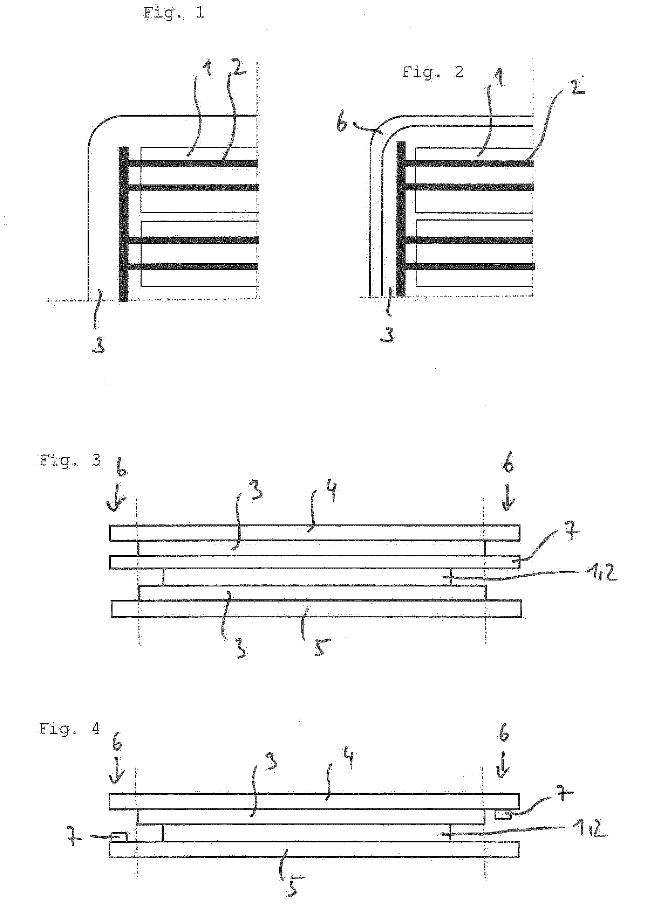

Fig. 1 zeigt einen Ausschnitt eines bekannten Photovoltaik-Paneels, bei dem Solarzellen 1 und elektrisch leitende Elemente 2 durch ein faserverstärktes Verbundmaterial als Fasermaterial 3 eingekapselt sind. Auf der dem Licht zugewandten Seite ist eine transparente Frontabdeckung 4 in Form einer ETFE-Folie vorgesehen. Auf der dem Licht abgewandten Seite ist eine Rückseitenabdeckung 5 in Form einer Folie vorgesehen. Das Verbundmaterial verläuft bis zu den Rändern der Front- und Rückseitenfolie.

Fig. 2 unterscheidet sich von Fig. 1 darin, dass die Front- und Rückseitenfolie jeweils in Richtung ihres Randes über das Verbundmaterial hinausragt, so dass das Verbundmaterial derart von den Rändern der Front- und Rückseitenfolie beabstandet ist, dass ein Randbereich 6 frei von Fasermaterial 3 ist. Die Front- und Rückseitenfolie sind in den Randbereichen 6 flüssigkeits- und gasdicht miteinander verbunden. Die Ränder der Front- und Rückseitenfolie schließen bündig miteinander ab.

Im Folgenden werden mögliche Schichtaufbauten beispielhaft dargestellt, soweit es für das Verständnis notwendig ist. Es versteht sich, dass weitere Schichten, z.B. Folien oder weitere Faserschichten vorgesehen sein können und dass zusätzlich zum Fasermaterial 3 eine weitere Komponente zum Ausbilden eines Verbundmaterials vorgesehen sein kann. Die Solarzelle 1 kann elektrisch leitende Elemente 2 umfassen.

Gemäß Fig. 3 ist mittig wenigstens eine Solarzelle 1 vorgesehen, die beidseitig von einem Fasermaterial 3 bedeckt ist. Das Fasermaterial 3 ragt über die wenigstens eine Solarzelle 1 hinaus. Die Fasermaterialien 3 sind jeweils mit einer Front- bzw. Rückseitenfolie bedeckt, die über das entsprechende Fasermaterial 3 hinausragt, so dass ein Randbereich 6 entsteht, der frei von Fasermaterial 3 ist. Zischen der Solarzelle 1 und dem Fasermaterial 3 an der dem Licht zugewandten Seite ist als Abdichtungsmaterial 7 eine Einkapselungsfolie vorgesehen, deren Fläche der Fläche der Front- und Rückseitenfolie entspricht. Die Einkapselungsfolie kann alternativ oder zusätzlich zwischen der Solarzelle 1 und dem Fasermaterial 3 an der dem Licht abgewandten Seite vorgesehen sein. Beim Laminieren des Aufbaus kapselt das Fasermaterial 3 die wenigstens eine Solarzelle 1 beidseitig ein und die Randbereiche 6 der Front- und Rückseitenfolie, die frei von Fasermaterial 3 sind, werden durch die Einkapselungsfolie verklebt. Zusätzlich zur Einkapselungsfolie kann auch noch ein weiteres Abdichtungsmaterial 7 verwendet werden.

Gemäß Fig. 4 ist mittig wenigstens eine Solarzelle 1 vorgesehen, die nur an der dem Licht zugewandten Seite mit einem Fasermaterial 3 bedeckt ist. Alternativ dazu kann das Fasermaterial 3 auch nur an der dem Licht abgewandten Seite vorgesehen sein. Alternativ kann auch zu beiden Seiten der wenigstens einen Solarzelle 1 Fasermaterial 3 angeordnet sein. Die mechanische Stabilität des Aufbaus kann dadurch gewährleistet werden, dass entweder die Frontabdeckung 4 oder die Rückseitenabdeckung 5 durch eine stabile Platte gebildet ist. Im Falle der Frontabdeckung 4 ist die stabile Platte eine transparente Platte, insbesondere eine Glasplatte. Im Falle der Rückseitenabdeckung 5 kann die stabile Platte eine geeignete Trägerschicht sein. In diesem Fall kann zwar eine Einkapselungsfolie als Abdichtungsmittel 7 vorgesehen sein, jedoch kann alternativ oder zusätzlich dazu ein Klebstoff als Abdichtungsmittel 7 im Randbereich 6, der frei von Fasermaterialien 3 ist, derart aufgetragen werden, dass beim Laminieren des Aufbaus der Randbereich 6 vorzugsweise vollflächig verklebt wird. Wenn eine stabile Platte und eine Folie als Front- bzw. Rückseitenabdeckung 4, 5 verwendet wird, dann kann die Fläche der stabilen Platte größer sein als die Fläche der Folie.

## Patentansprüche

1. Photovoltaik-Paneel umfassend
- eine an der dem Licht zugewandten Seite vorgesehene, flächige und transparente Frontabdeckung (4),
- eine an der dem Licht abgewandten Seite vorgesehene, flächige Rückseitenabdeckung (5),
- wobei die Front- und Rückseitenabdeckung (4, 5) jeweils einen umlaufenden Rand hat,
- und wenigstens eine Solarzelle (1) zwischen der Front- und Rückseitenabdeckung (4, 5),
- wobei zwischen der wenigstens einen Solarzelle (1) und der Frontabdeckung (4) und/oder zwischen der wenigstens einen Solarzelle (1) und der Rückseitenabdeckung (5) wenigstens ein Fasermaterial (3), das die wenigstens eine Solarzelle (1) bedeckt, vorgesehen ist
- und wobei das Fasermaterial (3) vorzugsweise ein Verbundmaterial, insbesondere ein mit Fasern verstärkter Kunststoff, ist,
**dadurch gekennzeichnet, dass**
- die Front- und Rückseitenabdeckung (4, 5) jeweils in Richtung ihres Randes über das Fasermaterial (3) hinausragen, so dass das Fasermaterial (3) derart von den Rändern der Front- und Rückseitenabdeckung (4, 5) beabstandet ist, dass ein Randbereich (6) frei von Fasermaterial (3) ist,
- und dass die Front- und Rückseitenabdeckung (4, 5) in dem Randbereich (6), der frei von Fasermaterial (3) ist, miteinander verbunden ist.

2. Photovoltaik-Paneel nach Anspruch 1, **dadurch gekennzeichnet, dass** der Randbereich (6), der frei von Fasermaterial (3) ist, zumindest entlang eines Teils der Ränder verläuft, insbesondere entlang der gesamten Ränder.

3. Photovoltaik-Paneel nach Anspruch 1 oder 2, **dadurch gekennzeichnet, dass** die Front- und Rückseitenabdeckung (4, 5) in dem Randbereich (6), der frei von Fasermaterial (3) ist, mittels eines Abdichtungsmaterials (7) miteinander verbunden ist.

4. Photovoltaik-Paneel nach Anspruch 4, **dadurch gekennzeichnet, dass** das Abdichtungsmaterial (7) eine thermoplastische oder duroplastische Folie und/oder ein Klebstoff, insbesondere ein pastöser und/oder flüssiger Kunststoff ist, mittels der/dem die Front- und Rückseitenfolie (4, 5) im Randbereich (6) miteinander verklebt ist.

5. Photovoltaik-Paneel nach einem der Ansprüche 1 bis 4, **dadurch gekennzeichnet, dass** der Randbereich (6), der frei von Fasermaterial (3) ist, flächig ist und im Wesentlichen parallel zu den Flächen der Front- und Rückseitenabdeckung (4, 5) verläuft.

6. Photovoltaik-Paneel nach einem der Ansprüche 1 bis 5, **dadurch gekennzeichnet, dass** die Frontabdeckung (4) eine transparente Platte, insbesondere eine Glasplatte, oder eine transparente Folie, insbesondere eine ETFE-Folie, ist.

7. Photovoltaik-Paneel nach einem der Ansprüche 1 bis 6, **dadurch gekennzeichnet, dass** die Rückseitenbedeckung (5) eine stabile Trägerschicht oder eine Folie ist.

8. Photovoltaik-Paneel nach einem der Ansprüche 1 bis 7, **dadurch gekennzeichnet, dass** das Verbundmaterial ein mit Fasern verstärkter Kunststoff auf Harzbasis, insbesondere auf Basis eines Acrylats enthaltend Epoxidgruppen ist, wobei das Acrylat enthaltend Epoxidgruppen vorzugsweise Glycidylmethacrylat ist.

9. Photovoltaik-Paneel nach einem der Ansprüche 1 bis 8, **dadurch gekennzeichnet, dass** die Fasern Glasfasern, Kunststofffasern, Basaltfasern oder Carbonfasern, Natur- und/oder Steinfasern sind.

10. Photovoltaik-Paneel nach einem der Ansprüche 1 bis 9, **dadurch gekennzeichnet, dass** das Fasermaterial (3) mindestens 0,1 cm, vorzugsweise mindestens 0,5 cm, insbesondere 1 cm, von den Rändern der Front- und/oder Rückseitenabdeckung (4, 5) beabstandet ist.

11. Verfahren zum Herstellen eines Photovoltaik-Paneels nach einem der Ansprüche 1 bis 10, umfassend die Schritte:
- Bereitstellen und gegebenenfalls Zuschneiden eines Fasermaterials (3) mit einer Fläche, die abhängig von der Fläche der wenigstens einen zu bedeckenden Solarzelle (1) gewählt wird,
- Bereitstellen und gegebenenfalls Zuschneiden einer Front- und einer Rückseitenabdeckung (4, 5) mit einer Fläche, die größer ist als die Fläche des Fasermaterials (3),
- Anordnen der wenigstens einen Solarzelle (1) und des Fasermaterials (3) zwischen der Front- und einer Rückseitenabdeckung (4, 5), wobei das Fasermaterial (3) gegebenenfalls mit wenigstens einer weiteren Komponente zum Ausbilden eines Verbundmaterials in Verbindung gebracht wird, wobei die Front- und Rückseitenabdeckung (4, 5) jeweils in Richtung ihres Randes über das Fasermaterial (3) hinausragend angeordnet werden, so dass das Fasermaterial (3) derart von den Rändern der Front- und Rückseitenabdeckung (4, 5) beabstandet ist, dass ein Randbereich (6) frei von Fasermaterial (3) gelassen wird,
- Laminieren des gesamten Aufbaus und Verbinden der Front- und Rückseitenabdeckung (4, 5) in den Randbereichen (6), die fei von Fasermaterial (3) sind.

12. Verfahren nach Anspruch 11, **dadurch gekennzeichnet, dass** wenigstens ein Abdichtungsmaterial (7) vorzugsweise vor dem Laminieren zwischen der Front- und Rückseitenabdeckung (4, 5) angeordnet wird.

13. Verfahren nach Anspruch 12, **dadurch gekennzeichnet, dass** wenigstens ein Abdichtungsmaterial (7) auf die Fläche des Randbereiches (6) der Front- und/oder Rückseitenabdeckung (4, 5), die frei von Fasermaterial (3) ist, aufgetragen wird, wobei das Abdichtungsmaterial (7) diese Randbereiche (6) miteinander verklebt.

14. Verfahren nach Anspruch 12 oder 13, **dadurch gekennzeichnet, dass** als Abdichtungsmaterial (7) eine thermoplastische und/oder duroplastische Folie und/oder ein Klebstoff, insbesondere ein pastöser und/oder flüssiger Kunststoff, verwendet wird.

15. Verfahren nach einem der Ansprüche 11 bis 14, **dadurch gekennzeichnet, dass** als Fasermaterial (3) ein Fasergewebe verwendet wird und als weitere Komponente ein pulverförmiges Harz, insbesondere eine Acrylat enthaltend Epoxidgruppen, vorzugsweise Glycidylmethacrylat, auf das Fasergewebe aufgetragen wird.

16. Verfahren nach einem der Ansprüche 11 bis 15, **dadurch gekennzeichnet, dass** die Fläche des Fasermaterials (3) und die Flächen der Front- und Rückseitenabdeckung (4, 5) derart bemessen werden, dass das Fasermaterial (3) im Photovoltaik-Paneel mindestens 0,1 cm, vorzugsweise 0,5 cm, insbesondere 1 cm, von den Rändern der Front- und Rückseitenabdeckung (4, 5) beabstandet ist.
